(19) Europäisches Patentamt

European Patent Office

Office européen des brevets

(11) **EP 1 688 958 A1**

(12) **EUROPÄISCHE PATENTANMELDUNG**

(43) Veröffentlichungstag:
09.08.2006 Patentblatt 2006/32

(51) Int Cl.:
*G11C 16/02* (2006.01)    *H01L 45/00* (2006.01)

(21) Anmeldenummer: 06001012.1

(22) Anmeldetag: 18.01.2006

(84) Benannte Vertragsstaaten:
AT BE BG CH CY CZ DE DK EE ES FI FR GB GR HU IE IS IT LI LT LU LV MC NL PL PT RO SE SI SK TR
Benannte Erstreckungsstaaten:
AL BA HR MK YU

(30) Priorität: 31.01.2005 DE 102005004434

(71) Anmelder: Infineon Technologies AG
81669 München (DE)

(72) Erfinder:
• Pinnow, Cay-Uwe
 81929 München (DE)
• Symanczyk, Ralf
 81673 München (DE)

(74) Vertreter: Charles, Glyndwr
Reinhard, Skuhra, Weise & Patrner GbR
Friedrichstrasse 31
80801 München (DE)

(54) **Verfahren und Vorrichtung zur Ansteuerung von Festkörper-Elektrolytzellen**

(57) Die Erfindung schafft eine elektrische Schaltvorrichtung, bei der eine elektrische Durchschaltung mittels eines Aufbaus eines Leitungspfads (101) in einem Schaltelement (100) herbeigeführt wird, wobei das Schaltelement (100) eine erste Elektrodeneinheit (201), eine zweite Elektrodeneinheit (202) und eine zwischen den ersten und zweiten Elektrodeneinheiten (201, 202) angeordnete und mit diesem kontaktierte Elektrolytschicht (203) aufweist. Der Leitungspfad (101) wird zwischen der ersten Elektrodeneinheit (201) und der zweiten Elektrodeneinheit (202) über die Elektrolytschicht (203) durch aus der ersten Elektrodeneinheit (201) in die Elektrolytschicht (203) diffundierte Leitungselemente (102) gebildet, wobei eine Heizeinrichtung (400) das Schaltelement (100) während des Schaltvorgangs aufheizt.

FIG 3

EP 1 688 958 A1

**Beschreibung**

Die vorliegende Erfindung betrifft allgemein Speicherzellen auf der Grundlage von Festkörperelektrolyten, und betrifft insbesondere Schaltvorgänge, wie etwa ein Löschen und/oder ein Setzen (Programmieren) von Festkörper-Elektrolytzellen, und eine Schaltvorrichtung zur Durchführung des Verfahrens. Insbesondere betrifft die vorliegende Erfindung ein Schaltverfahren zur Beschleunigung von Schaltvorgängen innerhalb eines Festkörperelektrolyten einer Speicherzelle.

Spezifisch betrifft die vorliegende Erfindung eine elektrische Schaltvorrichtung, bei der eine elektrische Durchschaltung mittels eines Aufbaus eines Leitungspfades in einem Schaltelement herbeigeführt wird bzw. bei der eine elektrische Abschaltung mittels eines Abbaus des Leitungspfads in dem Schaltelement herbeigeführt wird. Das Schaltelement weist hierbei eine erste Elektrodeneinheit, eine zweite Elektrodeneinheit und eine zwischen den ersten und zweiten Elektrodeneinheiten angeordnete und mit diesen kontaktierte Elektrolytschicht auf, wobei der Leitungspfad zwischen der ersten Elektrodeneinheit und der zweiten Elektrodeneinheit über die Elektrolytschicht durch aus der ersten Elektrodeneinheit in die Elektrolytschicht diffundierten Leitungselementen ausgebildet ist.

Zum Aufbau von Speicherzellen eignen sich u.a. so genannte CB-Zellen (Conductive Bridging, "leitfähiges Überbrücken"), die auch als Festkörperelektrolyt-Speicherzellen bezeichnet werden. Derartige Speicherzellen bestehen üblicherweise aus einer Anode, einer Kathode und einem zwischen der Anode und der Kathode angeordneten Ionenleiter. Die Speicherzelle ist hierbei als ein resistiv schaltendes Element ausgebildet, dessen Gesamtleitfähigkeit einem Speicherzustand zugeordnet werden kann. Zur Erfassung des Zustands der Zelle, d.h. zur Erfassung eines logischen Zustands (logisch "1" bzw. logisch "0"), wird der Strom bei einer vorbestimmten angelegten Lesespannung $U_{lese}$ ausgewertet.

Im Folgenden wird die Funktion einer derartigen CB-Zelle erläutert. Metallische Ionen werden durch den im Allgemeinen elektrisch schlecht leitenden Ionenleiter durch Anlegen bipolarer Spannungspulse aus dem Anodenmaterial diffundiert. Die üblicherweise metallischen Ionen sind im einfachsten Fall identisch mit dem Anodenmaterial. Üblicherweise wird der leitende Zustand der Zelle als der "Ein"-Zustand definiert, während der nicht-leitende Zustand der Zelle als der "Aus"-Zustand definiert wird. Das Erzeugen des leitenden Zustands wird als ein Schreibvorgang bezeichnet, während das Aufheben des leitenden Zustands, d.h. das Herbeiführen des nichtleitenden Zustands, als ein Löschvorgang definiert wird.

Bei dem Schreibvorgang wird infolge eines Anlegens einer positiven Schreibspannung $U_{schreib} > U_{lese}$ ein metallisches Anodenmaterial oxidiert und geht in den Festkörper-Ionenleiter in Lösung. Eine derartige Ionendiffusion kann durch eine Zeitdauer, eine Amplitude und eine Polarität der eingeprägten elektrischen Spannung, die an die Zelle angelegt wird, bzw. des eingeprägten elektrischen Stroms gesteuert werden. Nach einer Diffusion einer ausreichenden Anzahl von Metallionen von der Anode in das Festkörperelektrolytmaterial kann sich eine niederohmige metallische Brücke zwischen der Anode und der Kathode ausbilden, derart, dass der elektrische Widerstand der Speicherzelle beträchtlich absinkt.

Ein Löschvorgang wird durch Anlegen einer Löschspannung $U_{lösch}$, die eine im Vergleich zu der Lesespannung $U_{schreib}$ umgekehrte Polarität aufweist, herbeigeführt. Hierbei wird die beim Schreibvorgang gebildete metallische Brücke durch eine Ionendiffusion vom Ionenleiter zurück zu der Anode und eine anschließende Reduktion der Metallionen an der Anode unterbrochen, wodurch der Widerstand der Zelle beträchtlich ansteigt.

Ein wesentlicher Nachteil herkömmlicher CB-Zellen besteht darin, dass insbesondere bei einem Löschvorgang hohe Spannungen zu hohen Stromdichten und damit zu der Möglichkeit von Beschädigungen der Zelle führen. Andererseits ist es unzweckmäßig, niedrige Löschspannungen einzusetzen, da ein langsames Diffundieren der Ionen in die Anode zu einer nachteiligen Verringerung der Schaltgeschwindigkeit führt.

Herkömmliche CB-Zellen beruhen auf einem Programmieren (Schreiben) und Löschen der Speicherzelle ausschließlich durch elektrische Spannungspulse in Vorwärts- bzw. Rückwärtsrichtung. Üblicherweise werden zum Schreiben Spannungspulse eingesetzt, die über der Schwelle einer elektrolytischen Oxidation des jeweiligen Metallmaterials bzw. über der Schwelle zur Erzeugung eines Metallions liegen, beispielsweise größer als 0,23 V für eine aus einem selenhaltigen Festkörperelektrolyten mit Silberionen gebildete CB-Zelle.

Andererseits werden zum Löschen Spannungspulse eingesetzt, die ausreichend hoch sind, um diese Metall-Kationen wieder von ihren Positionen in Festkörperelektrolyt aus der metallhaltigen Brücke kooperativ zurück in Richtung der (ursprünglichen) Anode zu treiben. Um diesen kooperativen Ionenwanderungsprozess derart auszulegen, dass dieser eine hohe Schaltgeschwindigkeit aufweist, müssen einerseits relativ hohe Pulsamplituden angelegt werden, während die Feldstärken andererseits nicht zu übermäßigen Stromdichten in der Zelle führen dürfen, um eine Beschädigung der Zelle zu vermeiden. Es sei darauf hingewiesen, dass zum Erreichen hoher elektrischer Felder und somit hoher Ionen-Wanderungsgeschwindigkeiten stets aufgrund der folgenden Gleichung hohe Pulsamplituden erforderlich sind:

$$v = \mu \cdot E,$$

und

$$U/d = E$$

wobei $\mu$ = Ionenbeweglichkeit,
U = Spannung,
d= Schichtdicke,
v = Ionen-Wanderungsgeschwindigkeit, und
E = elektrische Feldstärke.

Ein weiterer wesentlicher Nachteil des herkömmlichen Verfahrens zum Programmieren bzw. Löschen einer CB-Zelle besteht darin, dass das wiederholte Anlegen hoher Feldstärken zu einer Degradation des Festkörperelektrolytmaterials führt. Somit wird die CB-Zelle in unzweckmäßiger Weise nach einer Anzahl von Schaltvorgängen funktionsuntüchtig.

Ferner besteht ein Nachteil herkömmlicher CB-Zellen darin, dass durch lange Löschpulse lediglich ein asymmetrischer Betrieb der CB-Zelle möglich ist. Weiter ist es nachteilig, dass, um eine ausreichend hohe Datenrate bei einem Löschvorgang zu verwirklichen, das Speicherzellenfeld massiv parallel betrieben werden muss.

Es ist daher eine Aufgabe der vorliegenden Erfindung, eine elektrische Schaltvorrichtung auf der Basis von CB-Zellen derart auszulegen, dass bei einem Schreiben bzw. Löschen der CB-Zelle hohe Stromdichten vermieden werden, wobei gleichzeitig hohe Schaltgeschwindigkeiten erreicht und Schädigungen der CB-Zelle vermieden werden.

Diese Aufgabe wird erfindungsgemäß durch eine Schaltvorrichtung mit den Merkmalen des Patentanspruchs 1 und durch ein Speicherzellenfeld mit den Merkmalen des Patentanspruchs 10 gelöst. Ferner wird die Aufgabe durch ein in dem Patentanspruch 11 angegebenes Verfahren gelöst.

Weitere Ausgestaltungen der Erfindung ergeben sich aus den Unteransprüchen.

Ein wesentlicher Gedanke der Erfindung besteht darin, bei einem Schreiben bzw. Löschen einer CB-Zelle eine Aufheizung der CB-Zelle bereitzustellen, derart, dass ein thermisch unterstütztes Schreiben bzw. Löschen ermöglicht wird. Eine derartige CB-Zelle wird im folgenden als eine TACB-Zelle (Thermally Assisted Conductive Bridging, "thermisch unterstütztes leitfähiges Überbrücken") bezeichnet werden. Die Aufheizung geht hierbei über eine Joule'sche Erwärmung der Zelle durch den beim Schreiben und/oder Löschen durch die Zelle fliessenden Strom hinaus. Auf diese Weise erzielt die vorliegende Erfindung den Vorteil, dass ein Löschen und/ oder ein Schreiben mit hohen Pulsamplituden vermieden wird, wobei gleichzeitig eine hohe Schaltgeschwindigkeit erreicht wird. In vorteilhafter Weise wird ein Löschen durch einen thermisch induzierten Diffusionsprozess beschleunigt, da die Ionenbeweglichkeit mit der Erhöhung der Temperatur der TACB-Zelle zunimmt. Somit ist der Löschvorgang aufgrund der temperaturabhängigen Ionenbeweglichkeit in vorteilhafter Weise in der Geschwindigkeit erhöht.

Gemäß einem allgemeinen Aspekt weist die erfindungsgemäße Schaltvorrichtung, bei der eine elektrische Durchschaltung mittels eines Aufbaus eines Leitungspfads in einem Schaltelement herbeigeführt wird, ein Schaltelement auf, welches umfasst:

a) eine erste Elektrodeneinheit;

b) eine zweite Elektrodeneinheit; und

c) eine zwischen den ersten und zweiten Elektrodeneinheiten angeordnete und mit diesen kontaktierte Elektrolytschicht, wobei der Leitungspfad zwischen der ersten Elektrodeneinheit und der zweiten Elektrodeneinheit über die Elektrolytschicht durch aus der ersten Elektrodeneinheit in die Elektrolytschicht diffundierte Leitungselementen ausgebildet ist, und wobei ferner eine Heizeinrichtung zum Heizen des Schaltelements bereitgestellt ist.

Ferner weist das erfindungsgemäße Schaltverfahren, bei dem ein elektrischer Schaltvorgang durch einen Aufbau bzw. einen Abbau eines Leitungspfads in einem Schaltelement herbeigeführt wird, im Wesentlichen die folgenden Schritte auf:

a) Anschließen einer ersten Elektrodeneinheit;

b) Anschließen einer zweiten Elektrodeneinheit;

c) Bereitstellen einer Elektrolytschicht zwischen den ersten und zweiten Elektrodeneinheiten und Kontaktieren derselben mit den ersten und zweiten Elektrodeneinheiten; und

d) Erzeugen des Leitungspfads zwischen der ersten Elektrodeneinheit und der zweiten Elektrodeneinheit über die Elektrolytschicht durch ein Diffundieren von Leitungselementen aus der ersten Elektrodeneinheit in die Elektrolytschicht, wobei das Schaltelement während des Schaltvorgangs mittels einer Heizeinrichtung geheizt wird.

In den Unteransprüchen finden sich vorteilhafte Weiterbildungen und Verbesserungen des jeweiligen Gegenstandes der Erfindung.

Gemäß einer bevorzugten Weiterbildung der vorliegenden Erfindung ist das Schaltelement als eine Speicherzelle ausgebildet.

Gemäß einer weiteren bevorzugten Weiterbildung der vorliegenden Erfindung enthält die erste Elektrodeneinheit ein Donatormaterial.

Gemäß noch einer weiteren bevorzugten Weiterbildung der vorliegenden Erfindung ist die zweite Elektrodeneinheit aus einem chemisch inerten Material ausgebildet. Vorzugsweise dient die zweite Elektrodeneinheit als die Kathode des Schaltelements, während die erste Elektrodeneinheit als die Anode des Schaltelements ausgelegt ist.

Gemäß noch einer weiteren bevorzugten Weiterbildung der vorliegenden Erfindung ist die Elektrolytschicht aus einem Festkörperelektrolytmaterial ausgebildet. Vorzugsweise besteht das Festkörperelektrolytmaterial aus einem oder mehreren der Materialien aus der Gruppe Germanium-Selen ($Ge_xSe_{1-x}$), Germaniumsulfid ($Ge_xS_{1-x}$), Wolframoxid ($WO_x$), Kupfersulfid (Cu-S), Kupfer-Selen (Cu-Se), ähnlichen chalcogenidhaltigen Verbindungen oder binären IV-VI -Verbindungen. Weiterhin sind ternäre Chalcogenidverbindungen, beispielsweise mit Stickstoff, wie etwa GeSeN oder GeSN einsetzbar.

Gemäß noch einer weiteren bevorzugten Weiterbildung der vorliegenden Erfindung sind die aus der ersten Elektrodeneinheit in die Elektrolytschicht abgeschiedenen Leitungselement-Metallionen.

Gemäß noch einer weiteren bevorzugten Weiterbildung der vorliegenden Erfindung ist die Heizeinrichtung zum Heizen des Schaltelements als ein resistives Heizelement ausgelegt. Weiterhin ist es möglich, die Heizeinrichtung zum Heizen des Schaltelements als einen integralen Bestandteil des Schaltelements vorzusehen.

Das Heizelement ist vorzugsweise derart ausgelegt, das Schaltelement auf Temperaturen in dem Bereich zwischen 50°C und 350°C aufzuheizen.

Gemäß noch einer weiteren bevorzugten Weiterbildung der vorliegenden Erfindung treibt die Heizeinrichtung einen Strom zum Heizen des Schaltelements durch die aus der ersten Elektrodeneinheit, der Elektrolytschicht und der zweiten Elektrodeneinheit gebildeten Anordnung.

Ferner ist es auf vorteilhafte Weise möglich, das Schaltelement durch die Heizeinrichtung mittels Strompulsen aufzuheizen.

Auf diese Weise ermöglicht es die elektrische Schaltvorrichtung der vorliegenden Erfindung, dass Schaltvorgänge bei geringen Stromdichten und hohen Schaltgeschwindigkeiten durchgeführt werden.

Ausführungsbeispiele der Erfindung sind in den Zeichnungen dargestellt und in der nachfolgenden Beschreibung näher erläutert.

In den Zeichnungen zeigen:

Fig. 1(a) eine schematische Darstellung eines TACB-Schaltelements;

Fig. 1(b) den schematischen Aufbau des TACB-Schaltelements;

Fig. 2(a) das in Fig. 1(b) gezeigte TACB-Schaltelement, wobei Leitungselemente in das Festkörperelektrolytmaterial diffundiert sind, in einem "Aus"-Zustand;

Fig. 2(b) die in Fig. 1(b) gezeigte Zelle, wobei Leitungselemente in das Festkörperelektrolytmaterial diffundiert sind, in einem "Ein"-Zustand der TACB-Zelle;

Fig. 3 eine schematische Darstellung des TACB-Schaltelements mit zugeordneter Heizeinrichtung;

Fig. 4(a) die Anordnung des Schaltelements bzw. der TACB-Zelle mit Heizeinrichtung in einem Speicherzellenfeld, wobei eine Bitleitung als Heizleitung verwendet wird;

Fig. 4(b) Schaltelemente in einem Speicherzellenfeld mit zugeordneter Heizeinrichtung, wobei eine Kontaktierungsleitung als Anschlussleitungseinrichtung verwendet wird;

Fig. 5(a) in einem Speicherzellenfeld angeordnete TACB-Zellen, wobei zugeordnete Heizeinrichtungen über eine Löschleitung angeschlossen sind;

Fig. 5(b) die in Fig. 5(a) gezeigte Anordnung mit einem modifizierten Anschluss der TACB-Zellen an Bitleitungen bzw. Wortleitungen des Speicherzellenfelds;

Fig. 6 ein Heizeinrichtungs-Schaltelementpaar, bei dem das Schaltelement zwischen eine Bitleitung und eine Wortleitung geschaltet ist und das Heizelement an eine Löschleitung angeschlossen ist;

Fig. 7 eine Anordnung von Heizinrichtung-Schaltelementpaaren gemäß Fig. 6 in einem Speicherzellenfeld;

Fig. 8 ein Heizeinrichtungs-Schaltelementpaar, wobei das Schaltelement zwischen eine Bitleitung und eine Wortleitung geschaltet ist, während das Heizelement an eine Löschleitung angeschlossen ist, die parallel zu der Wortleitung angeordnet ist; und

Fig. 9 ein Speicherzellenfeld aus Heizeinrichtungs-Schaltelementpaaren gemäß Fig. 8.

In den Figuren bezeichnen gleiche Bezugszeichen gleiche oder funktionsgleiche Komponenten oder Schritte.

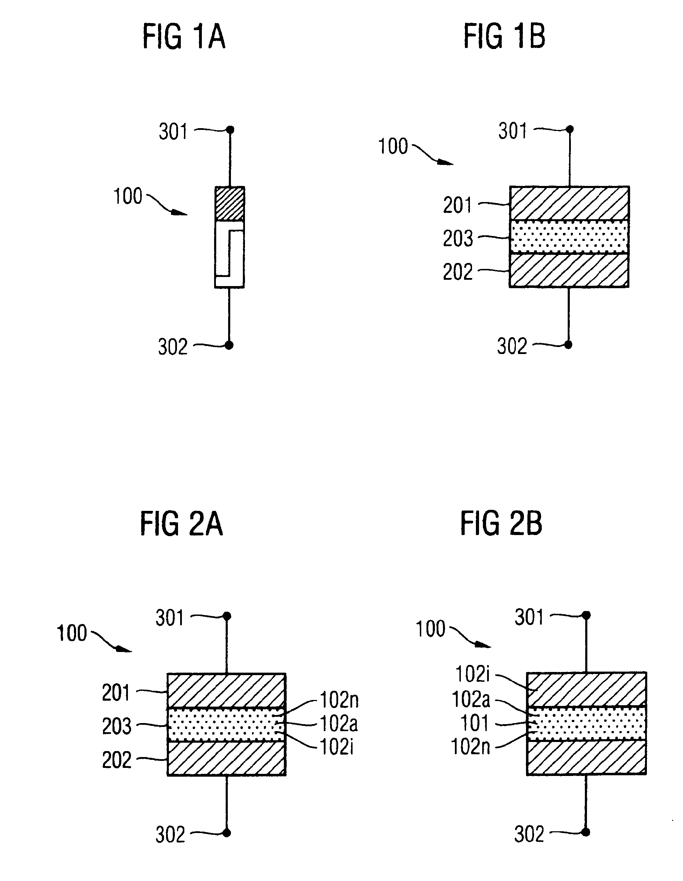

Eine erfindungsgemäße TACB-Zelle (Thermally Assisted Conductive Bridging, "thermisch unterstütztes leitfähiges Überbrücken") ist in den Fig. 1(a) und 1(b) dargestellt. Hierbei weist eine derartige TACB-Zelle, die im Folgenden mit dem Bezugszeichen 600 bezeichnet wird, im Wesentlichen zwei Anschlusseinheiten, d.h. eine erste Anschlusseinheit 301 und eine zweite Anschlusseinheit 302 für das Schaltelement 100 auf. Während Fig. 1(a) ein schematisches Schaltsymbol eines derartigen Schaltelements 100 trägt, ist in Fig. 1(b) der Aufbau des Schaltelements 100 schematisch dargestellt. Das Schaltelement 100 besteht im Wesentlichen aus einer ersten Elektrodeneinheit 201 und einer zweiten Elektrodeneinheit 202, wobei die erste Elektrodeneinheit 201 mit der ersten Schaltanschlusseinheit 301 verbunden ist, während die zweite Elektrodeneinheit 202 mit der zweiten Schaltanschlusseinheit 302 verbunden ist.

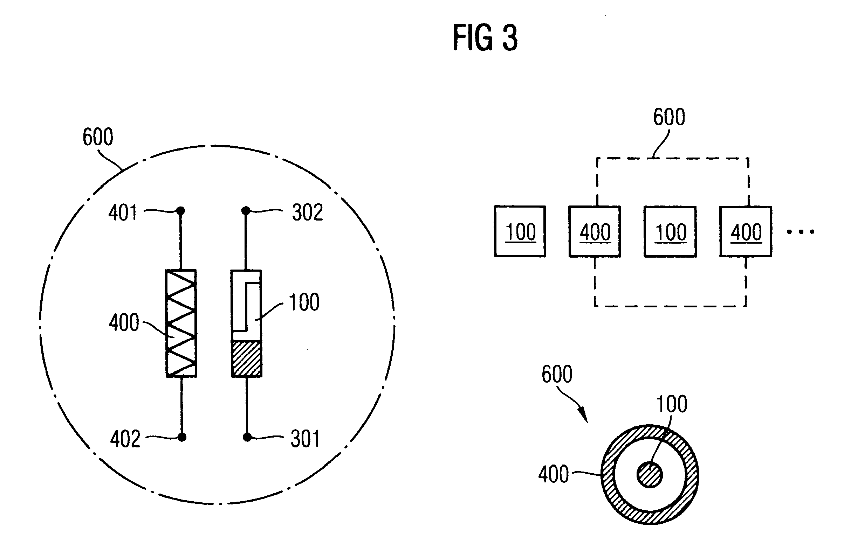

Wie unten stehend unter Bezugnahme auf Fig. 3 erläutert werden wird, weist die erfindungsgemäße elektrische Schaltvorrichtung neben dem Schaltelement 100 ferner eine Heizeinrichtung 400 auf, die auf dem oder in der Nähe des Schaltelements 100 angeordnet ist, so dass eine TACB-Zelle 600 ausgebildet wird.

Hierbei besteht das Grundprinzip darin, dass die elektrische Schaltvorrichtung, bei der eine elektrische Durchschaltung mittels eines Aufbaus eines Leitungspfads in dem Schaltelement 100 herbeigeführt wird, die Heizeinrichtung 400 zum Heizen des Schaltelements 100 aufweist. Genauer besteht das Schaltelement 100 aus der ersten Elektrodeneinheit 201, der zweiten Elektrodeneinheit 202 und einer zwischen den ersten und zweiten Elektrodeneinheiten 201, 202 angeordneten und mit diesen kontaktierten Elektrolytschicht 203, wobei der Leitungspfad zwischen der ersten Elektrodeneinheit 201 und der zweiten Elektrodeneinheit 202 über die Elektrolytschicht 203 durch aus der ersten Elektrodeneinheit 201 in die Elektrolytschicht 203 diffundierten Leitungselementen ausgebildet ist, wobei die Heizeinrichtung 400 das Schaltelement 100 während des Schaltvorgangs aufheizt. Durch die Kombination der Heizeinrichtung 400 mit dem Schaltelement 100 wird die TACB-Zelle 600 ausgebildet. Dabei kann die Heizeinrichtung 400 sowohl separate elektrische Kontakte aufweisen, als auch durch eine hochohmige Schicht in das Schaltelement 100 integriert ausgeführt sein.

Fig. 2(a) zeigt, dass aus der ersten Elektrodeneinheit 201 Leitungselemente 102a, 102b, ..., 102i, ..., 102n in die Elektrolytschicht 203 diffundiert sind. Es sei darauf hingewiesen, dass die zweite Elektrodeneinheit 202 als eine indifferente bzw. inerte Elektrode ausgebildet ist. Die erste Elektrodeneinheit 201 enthält somit ein Donatormaterial, das dafür sorgt, dass die Leitungselemente 102a-102n in die Elektrolytschicht 203 diffundieren. Fig. 2(a) zeigt einen "Aus"-Zustand des Schaltelements bzw. der TACB-Zelle, die als eine Speicherzelle ausgelegt sein kann. Der "Aus"-Zustand ist dadurch gekennzeichnet, dass sich in der Elektrolytschicht 203 zwar Leitungselemente 102a-102n befinden, diese jedoch keinen Leitungspfad zwischen der ersten Elektrodeneinheit 201 und der zweiten Elektrodeneinheit 202 ausbilden. Auf diese Weise ist eine elektrische Isolation zwischen der ersten Elektrodeneinheit 201 und der zweiten Elektrodeneinheit 202 sichergestellt, bzw. besteht zwischen den beiden Elektrodeneinheiten 201, 202 ein hoher elektrischer Widerstand.

Fig. 2(b) hingegen zeigt einen "Ein"-Zustand des Schaltelements 100, der dadurch gekennzeichnet ist, dass ein elektrischer Leitungspfad 101 zwischen der ersten Elektrodeneinheit 201 und der zweiten Elektrodeneinheit 202 gebildet ist. Wie in Fig. 2(b) gezeigt, ist an mindestens einer Stelle eine leitfähige Brücke (d.h. eine Überbrückung in dem leitfähigen Überbrückungs-Schaltelement) gebildet, derart, dass sich eine Anzahl von Leitungselementen 102a-102n derart berührt, dass der elektrische Widerstand zwischen der ersten Elektrodeneinheit 201 und der zweiten Elektrodeneinheit 202 verringert ist. Weiterhin kann ein derart kleiner Abstand bereitgestellt werden, dass ein quantenmechanischer Tunnelstrom ausgebildet wird, beispielsweise ein Abstand von weniger als 2 Nanometer (nm). Eine wie in Fig. 2(b) gezeigte Ausbildung eines Leitungspfads 101 wird auch als ein Schreiben bzw. ein "Programmieren" des Schaltelements bezeichnet.

Fig. 3 zeigt schließlich das Schaltelement 100 mit den ersten und zweiten Schaltanschlusseinheiten 301 bzw. 302, wobei dem Schaltelement 100 eine Heizeinrichtung 400 zugeordnet ist, die über eine erste Heizanschlusseinheit 401 und eine zweite Heizanschlusseinheit 402 an einen elektrischen Strompfad anschließbar ist. Die in Fig. 3 gezeigte Anordnung wird im Folgenden als ein Heizeinrichtungs-Schaltelementpaar, d.h. als eine TACB-Zelle 600 bezeichnet.

Durch die Heizeinrichtung 400 wird im Wesentlichen Joule'sche Wärme erzeugt, die genutzt werden kann, um das Schaltelement 100 von einem "Ein"-Zustand, d.h. in einem Zustand, in dem eine metallische/metallartige Brücke ausgebildet ist, in einen "Aus"-Zustand zu versetzen. Das grundlegende Prinzip besteht darin, dass die angelegte Joule'sche Wärme infolge der Stromdichte entlang der oben genannten metallischen oder metallartigen Bahn die zu löschende Zelle aufheizt und die daraus resultierende erhöhte diffusive Bewegung der metallischen Atome der Brücke innerhalb kürzester Zeit auflöst. Dieser Effekt wird bei der erfindungsgemäßen TACB-Zelle bzw. bei dem erfindungsgemäßen Schaltelement derart eingesetzt, dass dadurch, dass eine geeignet hohe Temperatur durch die Heizeinrichtung 400 bereitgestellt wird, der Diffusionsvorgang innerhalb von wenigen Nanosekunden (ns) zu einem "Aus"-Zustand des Schaltelements 100 führt.

Ferner ist es möglich, das elektrische Löschen lediglich thermisch zu unterstützen. Hierbei wird zeitgleich zum Heizvorgang ein elektrisches Feld derart angelegt, dass die Diffusion von Leitungselementen, die vorzugsweise als Metallatome ausgebildet sind, zurück in die erste Elektrodeneinheit 201 erfolgt. Hierbei besteht der Vorteil gegenüber herkömmlichen Schaltelementen auf der Basis von CB-Zellen darin, dass ein derartiges Löschen mit einer niedrigen Feldstärke bei gleichzeitigem Vorhandensein des Heizvorgangs durchgeführt werden kann. Ferner ist es vorteilhaft, dass die Löschdauer reduziert ist.

Es sei darauf hingewiesen, dass in gleicher Weise ein thermisch unterstütztes Schreiben bzw. "Programmieren" des Schaltelements bzw. der TACB-Zelle durchgeführt werden kann.

Dabei wird beim Schreiben und Löschen die physikalische Tatsache benutzt, dass die Beweglichkeit der Metallionen eine erhebliche Temperaturabhängigkeit aufzeigt, d.h. $\mu_{ion} = \mu_{ion}(T)$ mit $\mu(T_1) \ll \mu(T_2)$, falls $T_1 \ll T_2$ ist.

Prinzipiell sind drei Möglichkeiten eines erfindungsgemäßen Aufheizens des Schaltelements 100 durch die Heizeinrichtung 400 möglich:

a) der Heizstrom fließt direkt durch das Schaltelement 100;

b) der Heizstrom fließt nicht durch das Schaltelement 100, sondern lediglich durch die Heizeinrichtung 400, die in der Nähe des Schaltelements 100 (Heizeinrichtungs-Schaltelementpaar) angeordnet ist; und

c) der Heizstrom fließt teilweise durch das Schaltelement 100 und teilweise durch die Heizeinrichtung 400.

Die oben angegebenen Ausführungsformen unterscheiden sich hinsichtlich einer Ausführung und Kontaktierung der Heizeinrichtungen 400. In dem oben genannten Fall a) wird eine thermische Erwärmung dadurch erreicht, dass der Heizstrom direkt durch die Zelle oder durch ein in Serie geschaltetes Widerstandsheizelement (z.B. in Form einer resistiven Elektrode) geschickt wird, wobei das Heizelement direkt in die TACB-Zelle integriert ist. Eine derartige Anordnung kann durch eine geeignete Auswahl von parallelen oder seriellen Heizwiderständen verwirklicht werden.

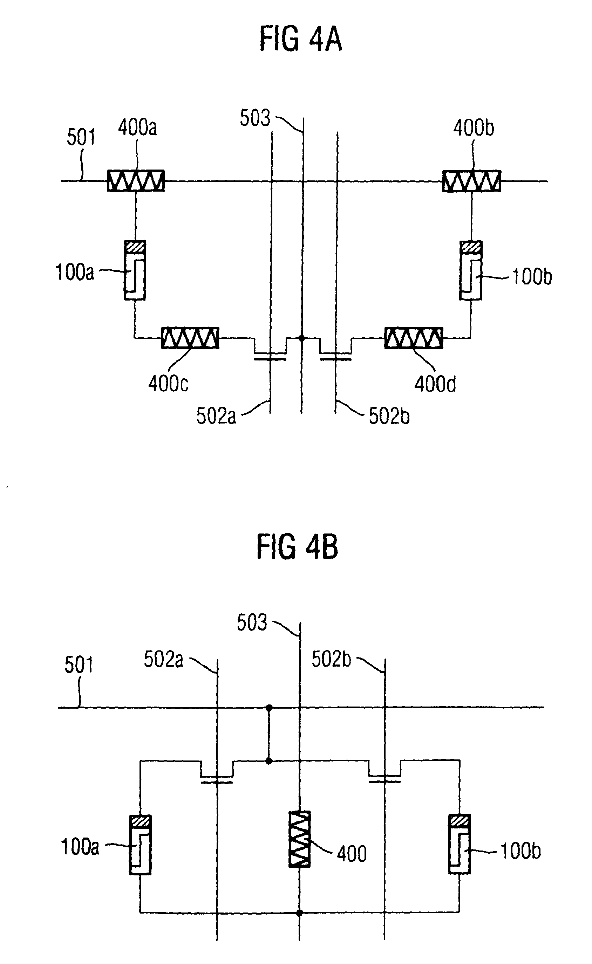

Die Ausführungsform d) kann dadurch verwirklicht werden, dass eine zusätzliche Heizleitung oder eine vorhandene Leitung, wie beispielsweise eine Verdrahtungsleitung, als eine Heizleitung eingesetzt wird, wie unten stehend unter Bezugnahme auf die Fig. 4-9 in unterschiedlichen Anordnungen erläutert werden wird.

Die Ausführungsform c) ist dementsprechend eine Kombination der Ausführungsformen a) und b).

Im Folgenden werden bevorzugte Ausführungsform der vorliegenden Erfindung unter Bezugnahme auf die Fig. 4-9 beschrieben werden.

Die unten beschriebenen Ausführungsformen zielen auf eine Ausbildung eines Speicherzellenfelds mit einem Array aus einer Vielzahl von erfindungsgemäßen Schaltelementen bzw. einer Vielzahl von Heizeinrichtungs-Schaltelementpaaren bzw. TACB-Zellen 600 ab.

Fig. 4(a) zeigt eine Anordnung, bei der zwei Heizeinrichtungs-Schaltelementpaare (bezeichnet jeweils durch die an die jeweiligen Bezugszeichen angehängten Buchstaben a, b, c, ..., i, ..., n) einsetzt sind.

Die entsprechenden Heizeinrichtungen 400a und 400b sind in dem in Fig. 4(a) gezeigten Ausführungsbeispiel dann an eine Bitleitung 501 angeschlossen, durch die zum Aufheizen der jeweiligen Schaltelemente 100a bzw. 100b ein ausreichend hoher Strom eingeführt werden muss. Die Schaltelemente 100a, 100b, die als Speicherzellen eingesetzt werden, sind hierbei jeweils zwischen der Bitleitung 501 und einer entsprechenden Wortleitung 502a bzw. 502b geschaltet. Ferner ist eine Kontaktierungsleitung 503 gezeigt, welche in dem in Fig. 4(a) gezeigten Ausführungsbeispiel durch das erfindungsgemäße Heizeinrichtungs-Schaltelementpaar nicht beaufschlagt ist.

Wie ferner in Fig. 4(a) veranschaulicht, können Heizelemente 400c, 400d zusätzlich oder anstelle von den Heizelementen 400a, 400b vorgesehen werden. Hierbei sind die zusätzlichen Heizelemente 400c, 400d in Serie zu den zugehörigen Schaltelementen 100a, 100b geschaltet.

Fig. 4(b) zeigt eine andere Anordnung, bei der die Kontaktierungsleitung 503 zum Anschluss der Heizeinrichtung 400 herangezogen wird. In der in Fig. 4(b) gezeigten Anordnung ist die Heizeinrichtung 400 zwischen den beiden Schaltelementen 100a, 100b angeordnet und heizt beide derartige Schaltelemente 100a, 100b auf. Die Schaltelemente selbst sind zwischen der Wortleitung 502a bzw. 500b und der Bitleitung 501 angeordnet.

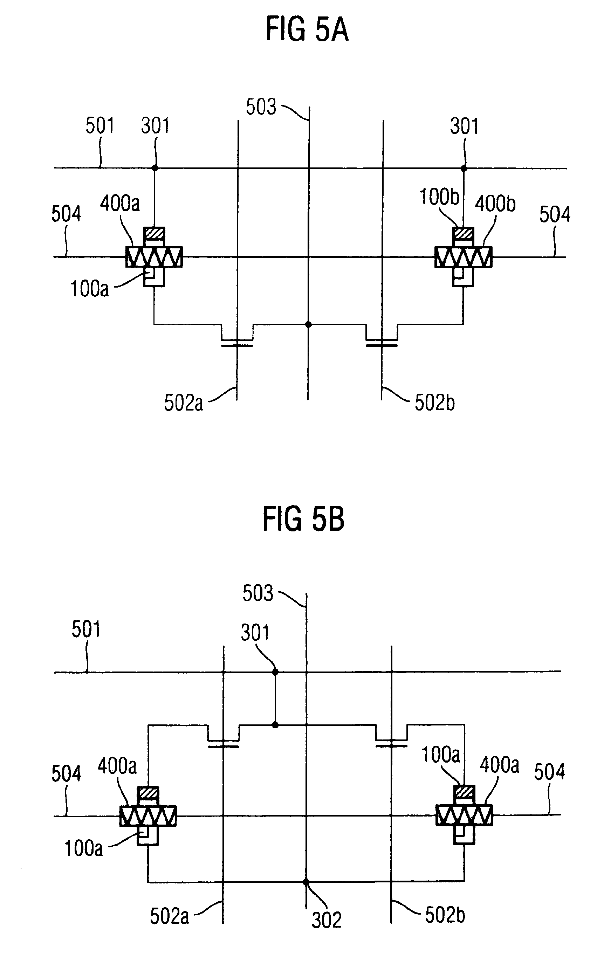

Fig. 5(a) zeigt ein weiteres Ausführungsbeispiel, bei dem der Strom für die Heizeinrichtung 400a bzw. 400b über die Löschleitung 504 zugeführt wird. Hierbei wird das entsprechende Schaltelement 100a, 100b über die Bitleitung 501 bzw. die Wortleitungen 502a, 502b angesteuert, während die Kontaktierungsleitung 503 mit der Heizeinrichtung 400 nicht beaufschlagt ist.

Fig. 5(b) zeigt eine Variante der in Fig. 5(a) gezeigten Anordnung. Wie in Fig. 5(b) gezeigt, ist hier die Löschleitung wiederum als Heizleitung ausgelegt, derart, dass der Löschstrom (bzw. der Schreibstrom) zum Aufheizen der Heizeinrichtung 400 über die Löschleitung 504 zugeführt wird.

Die jeweiligen Schaltelemente 100a, 100b sind zwischen der Bitleitung 501 und der Kontaktierungsleitung 503 mit den jeweiligen Schaltanschlusseinheiten 301 und den jeweiligen zweiten Schaltanschlusseinheiten 302 angeschlossen.

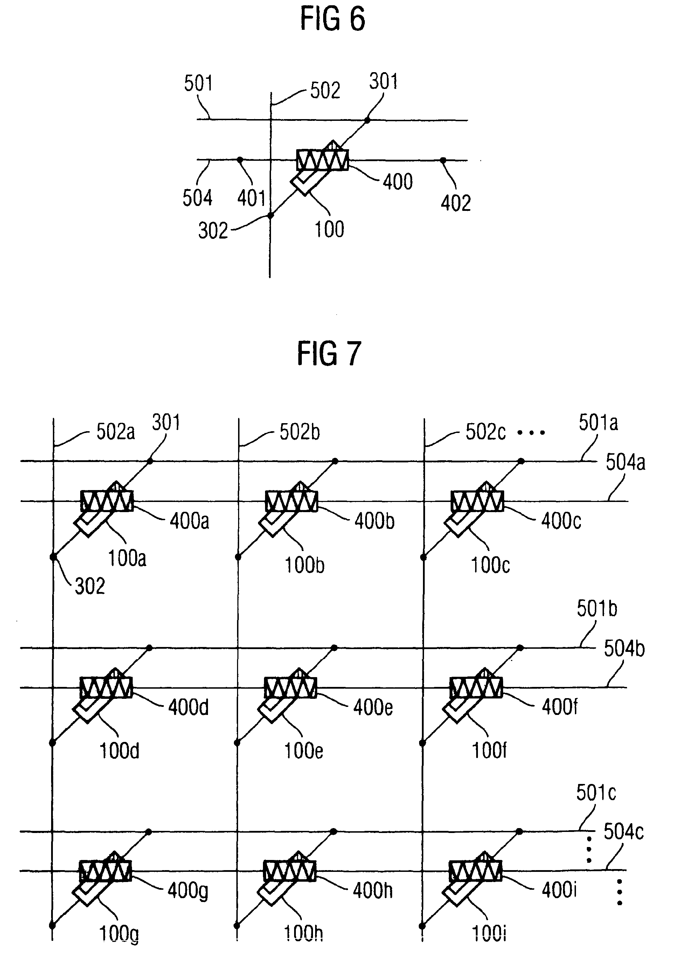

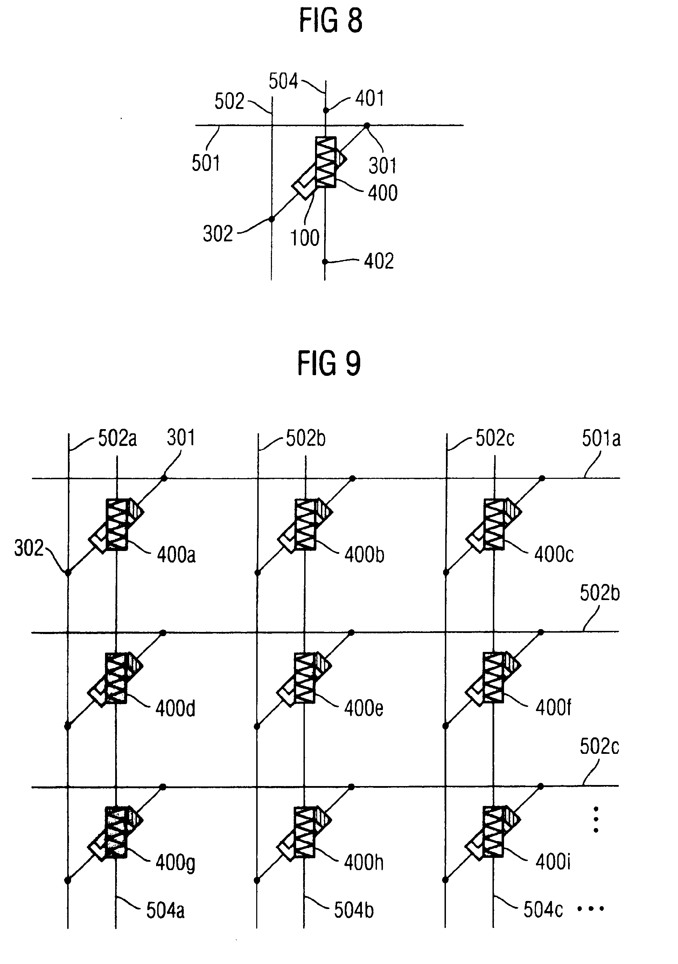

Die Fig. 6-9 zeigen die Ausbildung eines aus Heizeinrichtungs-Schaltelementpaaren bzw. TACB-Zellen 600 ausgebildeten Speicherzellenfelds in zwei unterschiedlichen Ausführungsformen. Während die Fig. 6 und 7 eine Anordnung zeigen, bei welcher in dem Speicherzellenfeld die Löschleitungen 504a-504n parallel zu den Bitleitungen 501a-501n ausgerichtet sind, sind in der in den Fig. 8 und 9 gezeigten Anordnung die Löschleitungen 504a-504n senkrecht zu den Bitleitungen 501a-501n angeordnet.

Fig. 6 zeigt ein Heizeinrichtungs-Schaltelementpaar bestehend aus der Heizeinrichtung 400 und dem Schaltelement 100, wobei das Schaltelement 100 über die erste Schaltanschlusseinheit 301 mit der Bitleitung 501 verbunden ist, während das Schaltelement 100 über die zweite Schaltanschlusseinheit 302 mit der Wortleitung 502 verbunden ist. Wie oben stehend unter Bezugnahme auf Fig. 3 gezeigt, weist die Heizeinrichtung 400 eine erste Heizanschlusseinheit 401 und eine zweite Heizanschlusseinheit 402 auf, die in der in Fig. 6 gezeigten Anordnung mit der Löschleitung 504 verbunden sind.

Fig. 7 zeigt ein Speicherzellenfeld bestehend aus Heizeinrichtungs-Schaltelementpaaren bzw. TACB-Zellen 600 gemäß Fig. 6.

Die Anordnungen, die in den Fig. 8 und 9 gezeigt sind, entsprechen jenen der Fig. 6 und 7 dahingehend, dass eine Anordnung von Heizeinrichtungs-Schaltelementpaaren bzw. TACB-Zellen 600 in der Form eines Speicherzellenfelds ausgelegt ist. Wie in Fig. 8 gezeigt, ist das Schaltelement 100 über die erste Schaltanschlusseinheit 301 mit der Bitleitung 501 verbunden, während das Schaltelement 100 über die zweite Schaltanschlusseinheit 302 mit der Wortleitung 502 verbunden ist. Die Wortleitung 502 ist parallel zu der Löschleitung 504 ausgerichtet, in welcher die Heizeinrichtung 400 des Heizeinrichtungs-Schaltelementpaares bzw. der TACB-Zelle 600 liegt.

Die Heizeinrichtung 400 ist über die erste Heizanschlusseinheit 401 und die zweite Heizanschlusseinheit 402 mit der Löschleitung 504 verbunden.

Fig. 9 zeigt schließlich ein Speicherzellenfeld, das aus Heizeinrichtungs-Schaltelementpaaren bzw. TACB-Zellen 600 gemäß Fig. 8 besteht.

Während die Löschleitungen 504a-504n in der in Fig. 7 gezeigten Anordnung über oder unter dem Speicherzellenfeld parallel zu den Bitleitungen 501a-501n angeordnet werden können, sind die Löschleitungen 504a-504n in dem in Fig. 9 gezeigten Beispiel parallel zu den jeweiligen Wortleitungen 502a-502n angeordnet. Die in Fig. 7 gezeigte Anordnung weist den Vorteil auf, dass die resistiven Heizelemente an jedem Schaltelement durch die Löschleitungen 504a-504n angesprochen werden können, wobei das kritische Löschen in den "Crosspoint Arrays" durch Spannungspulse mit hohen Amplituden vermieden werden kann. Ein Nachteil dieser Anordnung besteht darin, dass auf diese Weise sämtliche einer Bitleitung 501a-501n zugeordneten Zellen gelöscht werden (auch als ein "block erase" bezeichnet).

Hingegen werden in der in Fig. 9 gezeigten Anordnung sämtliche Zellen, die einer entsprechenden Wortleitung 502a, 502n zugeordnet sind, in einem Löschvorgang gelöscht.

Das Festkörperelektrolytmaterial, aus welchem die Elektrolytschicht 203 ausgebildet ist (siehe u.a. Fig. 2(a) und (b)) ist vorzugsweise aus einem oder mehreren Materialien aus der Gruppe Germanium-Selen ($Ge_xSe_{1-x}$), Germaniumsulfid ($Ge_xS_{1-x}$), Wolframoxid ($WO_x$), Kupfersulfid (Cu-S), Kupfer-Selen (Cu-Se) oder ähnlichen, beispielsweise binären oder ternären chalcogenidhaltigen Verbindungen gebildet.

Die aus der ersten Elektrodeneinheit 201 in die Elektrolytschicht 203 abgeschiedene Leitungselemente sind vorzugsweise Cluster von Metallionen, Metallverbindungen oder metallhaltigen Ausscheidungen mit typischen Durchmessern in einem Bereich von 5-10 nm.

Es besteht die Möglichkeit, dass sich das Metall in einer TACB-Zelle 600 nach vielen Heizpulsen in dem Festkörperelektrolyt kumulativ agglomeriert. Daher kann es notwendig sein, durch geeignete zusätzliche elektrische Löschpulse die TACB-Zellen 600 in einen ursprünglichen Zustand zurückzuversetzen. Dies kann jedoch vom Schaltungsdesign derart berücksichtigt werden, dass Rücksetzpulse, welche dem Benutzer des Schaltungselements verborgen bleiben, so eingebracht werden, dass diese Pulse nach den eigentlichen Betriebszyklen, z.B. bei einem Einschalten der Schaltungsanordnung oder bei einem Ausschalten der Schaltungsanordnung durchgeführt werden. An derartige Lösch- bzw. Schreibpulse werden jedoch keine hohen Geschwindigkeitsanforderungen gestellt.

Durch die Temperaturabhängigkeit der Ionenbeweglichkeit $\mu = \mu(T)$ wird der thermisch induzierte Diffusionsprozess ermöglicht. Eine Aktivierungsenergie für das thermische Löschen, d.h. für den Übergang eines "Ein"-Widerstands von ca. 10-100 k$\Omega$ auf einige G$\Omega$ oder höher, beträgt ungefähr 0,25 eV, was zu einer Löschzeit von einigen Mikrosekunden bis Nanosekunden führt, wenn durch die Heizeinrichtung 400 Temperaturen in einem Bereich von 190°C bis 200°C erzeugt werden. Derartige Temperaturen sind auf einfache Weise durch erzielbare Stromstärken in Widerstandsmaterialien auf der Basis des Joule'schen Effekts erzielbar und schädigen das aus den Heizeinrichtungs-Schaltelementpaaren bzw. TACB-Zellen 600 ausgebildete Speicherzellenfeld nicht.

Die Heizeinrichtung 400 zum Heizen des Schaltelements 100 kann als ein integraler Bestandteil des Schaltelements 100 ausgelegt werden. Durch die Kombination der Heizeinrichtung 400 mit dem Schaltelement 100 wird die "TACB-Zelle" 600 ausgebildet.

In einer bevorzugten Ausführungsform ist die Heizeinrichtung 400 zum Heizen des Schaltelements 100 als ein resistives Heizelement ausgebildet. Vorzugsweise treibt die Heizeinrichtung 400 einen Strom zum Heizen des Schaltelements 100 durch die aus der Elektrodeneinheit 201, der Elektrolytschicht 203 und der zweiten Elektrodeneinheit 202 gebildeten Anordnung. Hierbei ist es möglich, dass die Heizeinrichtung 400 das Schaltelement 100 mittels Strompulsen in einem gepulsten Betrieb aufheizt. Hierbei ist ein bipolares Pulsen einsetzbar, welches den Speicherzustand einer TACB-Zelle 600 nicht beeinflusst. Hierzu können Pulse mit einer Zeitdauer im Nanosekunden-Bereich und mit einer Pulsspannung unterhalb der Schaltschwelle ($V_t$ von ca. 0,25 V) herangezogen werden. Typische Temperaturen, auf welche die Heizeinrichtung 400 das entsprechende zugeordnete Schaltelement 100 aufheizt, liegen in einem Bereich zwischen 50°C und 350°C.

Bevorzugte Heizmaterialien umfassen Metalle und Metallnitride, insbesondere leitfähige Metallnitride von CMOS-Materialien wie $WN_x$, $TiN_x$, $TaN_x$, $TiSi_xN_y$, $TaSi_xN_y$, $WSi_xN_y$. Ferner lassen sich Metallsilizide wie $TiSi_x$, $WSi_x$, $CoSi_x$, $NiSi_y$, $TaSi_x$ oder dotierte polykristalline Siliziummaterialien wie n-poly-Si, p-poly-Si vorteilhaft einsetzen.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Auch ist die Erfindung nicht auf die genannten Anwendungsmöglichkeiten beschränkt.

Bezugszeichenliste

In den Figuren bezeichnen gleiche Bezugszeichen gleiche oder funktionsgleiche Komponenten oder Schritte.

| 100, | Schaltelement |
|---|---|
| 100a, | |
| 100b, ... | |
| 100i, ... | |
| 100n | |
| 101 | Leitungspfad |
| 102, | Leitungselemente |
| 102a, | |
| 102b, ... | |
| 102i, ... | |
| 102n | |
| 201 | erste Elektrodeneinheit |
| 202 | Zweite Elektrodeneinheit |
| 203 | Elektrolytschicht |
| 301 | Erste Schaltanschlusseinheit |
| 302 | Zweite Schaltanschlusseinheit |
| 400, | Heizeinrichtung |
| 400a, | |
| 400b, ... | |
| 400i, ... | |
| 400n | |
| 401 | Erste Heizanschlusseinheit |

| 402 | Zweite Heizanschlusseinheit |
|---|---|
| 501, | Bitleitung |
| 501a- | |
| 501n | |
| 502, | Wortleitung |
| 502a, | |
| 502b, ... | |
| 502n | |
| 503 | Kontaktierungsleitung |
| 504, | Löschleitung |
| 504a- | |
| 504n | |
| 600 | TACB-Zelle |

**Patentansprüche**

1. Elektrische Schaltvorrichtung, bei der eine elektrische Durchschaltung mittels eines Aufbaus eines Leitungspfads (101) in einem Schaltelement (100) herbeigeführt wird, wobei das Schaltelement (100) aufweist:

   a) eine erste Elektrodeneinheit (201);
   b) eine zweite Elektrodeneinheit (202); und
   c) eine zwischen den ersten und zweiten Elektrodeneinheiten (201, 202) angeordnete und mit diesen kontaktierte Elektrolytschicht (203), wobei
   d) der Leitungspfad (101) zwischen der ersten Elektrodeneinheit (201) und der zweiten Elektrodeneinheit (202) über die Elektrolytschicht (203) durch aus der ersten Elektrodeneinheit (201) in die Elektrolytschicht (203) diffundierte Leitungselemente (102) ausgebildet ist,
   **dadurch gekennzeichnet ,**
   **dass** die elektrische Schaltvorrichtung ferner aufweist:
   e) eine Heizeinrichtung (400) zum Heizen des Schaltelements (100).

2. Vorrichtung nach Anspruch 1,
   **dadurch gekennzeichnet ,**
   **dass** das Schaltelement (100) als eine Speicherzelle ausgebildet ist.

**3.** Vorrichtung nach Anspruch 1,
**dadurch gekennzeichnet ,**
**dass** die erste Elektrodeneinheit (201) ein Donatormaterial enthält.

**4.** Vorrichtung nach Anspruch 1,
**dadurch gekennzeichnet ,**
**dass** die zweite Elektrodeneinheit (201) aus einem chemisch inerten Material, das keine oder nur eine geringe Löslichkeit in dem Material der Elektrolytschicht (203) aufweist, ausgebildet ist.

**5.** Vorrichtung nach Anspruch 1,
**dadurch gekennzeichnet ,**
**dass** die Elektrolytschicht (203) aus einem Festkörperelektrolytmaterial ausgebildet ist.

**6.** Vorrichtung nach Anspruch 5,
**dadurch gekennzeichnet ,**
**dass** das Festkörperelektrolytmaterial, aus welchem die Elektrolytschicht (203) ausgebildet ist, eines oder mehrere von Materialien aus der Gruppe Germanium-Selen $(Ge_xSe_{1-x})$, Germaniumsulfid $(Ge_xS_{1-x})$, Wolframoxid $(WO_x)$, Kupfersulfid (Cu-S), Kupfer-Selen (Cu-Se) oder ähnlichen, beispielsweise binären oder ternären chalcogenidhaltigen Verbindungen enthält.

**7.** Vorrichtung nach Anspruch 1,
**dadurch gekennzeichnet ,**
**dass** die aus der ersten Elektrodeneinheit (201) in die Elektrolytschicht (203) abgeschiedenen Leitungselemente (102) Metallionen sind.

**8.** Vorrichtung nach Anspruch 1,
**dadurch gekennzeichnet ,**
**dass** die Heizeinrichtung (400) zum Heizen des Schaltelements (100) als ein resistives Heizelement ausgelegt ist.

**9.** Vorrichtung nach Anspruch 1 oder 8,
**dadurch gekennzeichnet ,**
**dass** die Heizeinrichtung (400) zum Heizen des Schaltelements (100) als ein integraler Bestandteil des Schaltelements (100) ausgelegt ist.

**10.** Speicherzellenfeld mit einem Array aus einer Vielzahl von Schaltelementen (100) gemäß Anspruch 1.

**11.** Schaltverfahren, bei dem ein elektrischer Schaltvorgang durch einen Aufbau bzw. einen Abbau eines Leitungspfads (101) in einem Schaltelement (100) herbeigeführt wird, wobei das Verfahren die folgenden Schritte aufweist:

a) Anschließen einer ersten Elektrodeneinheit (201);
b) Anschließen einer zweiten Elektrodeneinheit (202);
c) Bereitstellen einer Elektrolytschicht (203) zwischen den ersten und zweiten Elektrodeneinheiten (201, 202) und Kontaktieren derselben mit den ersten und zweiten Elektrodeneinheiten (201, 202); und
d) Erzeugen des Leitungspfads (101) zwischen der ersten Elektrodeneinheit (201) und der zweiten Elektrodeneinheit (202) über die Elektrolytschicht (203) durch ein Diffundieren von Leitungselementen (102) aus der ersten Elektrodeneinheit (201) in die Elektrolytschicht (203),
**dadurch gekennzeichnet , dass**
e) das Schaltelement (100) während des Schaltvorgangs mittels einer Heizeinrichtung (400) geheizt wird.

**12.** Verfahren nach Anspruch 11,
**dadurch gekennzeichnet ,**
**dass** aus der ersten Elektrodeneinheit (201) in die Elektrolytschicht (203) als Leitungselemente (102) Metallionen abgeschieden werden.

**13.** Verfahren nach Anspruch 11,
**dadurch gekennzeichnet ,**
**dass** die Heizeinrichtung (400) das Schaltelement (100) während des elektrischen Schaltvorgangs auf Temperaturen in dem Bereich zwischen 50 °C und 350 °C aufheizt.

**14.** Verfahren nach Anspruch 11,
**dadurch gekennzeichnet ,**
**dass** die Heizeinrichtung (400) einen Strom zum Heizen des Schaltelements (100) durch die aus der ersten Elektrodeneinheit (201), der Elektrolytschicht (203) und der zweiten Elektrodeneinheit (202) gebildeten Anordnung treibt.

**15.** Verfahren nach Anspruch 11 oder 14,
**dadurch gekennzeichnet ,**
**dass** die Heizeinrichtung (400) das Schaltelement (100) mittels Strompulsen aufheizt.

**16.** Verfahren nach Anspruch 15,
**dadurch gekennzeichnet ,**
**dass** die Heizeinrichtung (400) das Schaltelement (100) mittels Strompulsen aufheizt, wobei der Speicherinhalt des Schaltelements (100) unverändert bleibt.

# FIG 1A

301

100

302

# FIG 1B

100

301

201

203

202

302

# FIG 2A

100

301

201

203

202

102n

102a

102i

302

# FIG 2B

100

301

102i

102a

101

102n

302

# FIG 3

# FIG 4A

# FIG 4B

# FIG 5A

# FIG 5B

# FIG 6

# FIG 7

# FIG 8

# FIG 9

**Europäisches Patentamt**

## EUROPÄISCHER RECHERCHENBERICHT

Nummer der Anmeldung

EP 06 00 1012

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 3 886 577 A (BUCKLEY ET AL) 27. Mai 1975 (1975-05-27) * Spalte 4, Zeile 35 - Spalte 11, Zeile 49; Abbildungen 1,2,6 * ----- | 1-16 | INV. G11C16/02 H01L45/00 |
| A | US 6 084 796 A (KOZICKI ET AL) 4. Juli 2000 (2000-07-04) * Spalte 7, Zeile 29 - Spalte 10, Zeile 51; Abbildung 5c * ----- | 1,11 | |
| A | US 2003/137869 A1 (KOZICKI MICHAEL N) 24. Juli 2003 (2003-07-24) * Absätze [0038] - [0067]; Abbildungen 1,3 * ----- | 1,11 | |
| A | WO 97/05665 A (ENERGY CONVERSION DEVICES, INC) 13. Februar 1997 (1997-02-13) * Seite 14, Zeile 20 - Seite 29, Zeile 11; Abbildung 1 * ----- | 1,11 | |
| A | US 2004/037179 A1 (LEE SE-HO) 26. Februar 2004 (2004-02-26) * Absätze [0039] - [0044]; Abbildung 2a * ----- | 1,11 | RECHERCHIERTE SACHGEBIETE (IPC) G11C H01L |

Der vorliegende Recherchenbericht wurde für alle Patentansprüche erstellt

| Recherchenort | Abschlußdatum der Recherche | Prüfer |
|---|---|---|
| München | 28. Juni 2006 | Stocken, C |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**　　　EP 06 00 1012

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-06-2006

| Im Recherchenbericht angeführtes Patentdokument | Datum der Veröffentlichung | Mitglied(er) der Patentfamilie | Datum der Veröffentlichung |
|---|---|---|---|
| US 3886577　　A | 27-05-1975 | CA　　1041211 A1<br>DE　　2443178 A1<br>FR　　2243526 A1<br>GB　　1480402 A<br>GB　　1480401 A<br>IT　　1021283 B<br>JP　　1164162 C<br>JP　　50065177 A<br>JP　　57058786 B<br>NL　　7412121 A | 24-10-1978<br>13-03-1975<br>04-04-1975<br>20-07-1977<br>20-07-1977<br>30-01-1978<br>26-08-1983<br>02-06-1975<br>11-12-1982<br>14-03-1975 |
| US 6084796　　A | 04-07-2000 | KEINE | |
| US 2003137869　A1 | 24-07-2003 | KEINE | |
| WO 9705665　　A | 13-02-1997 | AU　　6504696 A<br>CA　　2227612 A1<br>DE　　69634007 D1<br>DE　　69634007 T2<br>EP　　0843901 A1<br>JP　　11510317 T | 26-02-1997<br>13-02-1997<br>13-01-2005<br>29-12-2005<br>27-05-1998<br>07-09-1999 |
| US 2004037179　A1 | 26-02-2004 | KEINE | |

Für nähere Einzelheiten zu diesem Anhang : siehe Amtsblatt des Europäischen Patentamts, Nr.12/82

EPO FORM P0461